# DEMANDE DE BREVET EUROPEEN

(11) **EP 3 040 611 A1**
(43) Date de publication de la demande: **06.07.2016**
(21) Numéro de dépôt: 15178276.0
(22) Date de dépôt: 24.07.2015
(51) Int. Cl.: F21V 19/00, F21S 8/10, H05K 1/02, H05K 1/18, H05K 3/18, F21Y 111/00

(54) **SUPPORT DE DIODES À ÉLECTROLUMINESCENCE (LED) POUR MODULE DE SIGNALISATION**

(30) Priorité: 31.07.2014 FR 1457415
(71) Demandeur: VALEO VISION, 93012 Bobigny Cedex (FR)
(72) Inventeur: LAUVERNIER, Denis, 94400 VITRY SUR SEINE (FR); ZOJCESKI, Zdravko, 92400 COURBEVOIE (FR)

(57) **Abrégé**

L'invention a trait à un support (102) de source(s) lumineuse(s) pour module d'éclairage et/ou de signalisation (122) notamment pour véhicule automobile, comprenant un substrat (114) avec au moins une ouverture (116) et des pistes électriques (110) sur au moins une face, au moins une diode à électroluminescence (LED) (106) avec un corps (118) et des pattes de connexion électrique (108) latérales au corps. La ou ou moins une des LED (106) est disposée au travers d'une ouverture respective (116) du substrat (114), et les pattes de connexion (108) sont en contact avec les pistes électriques respectives (110). Le substrat (114) est une pièce moulée rigide présentant une forme en trois dimensions pouvant assurer une fonction optique telle que celle d'un réflecteur. Dans ce cas, les LED (106) sont directement supportées par la pièce optique (114).

## Description

L'invention a trait au domaine de l'éclairage et de la signalisation lumineuse, notamment pour véhicule automobile. Plus précisément, l'invention a trait au domaine de l'éclairage et de la signalisation lumineuse au moyen de diodes à électroluminescence (LED), et plus particulièrement au montage desdites LED dans un module de signalisation.

Le document de brevet US 5,331,512 A divulgue le montage de LED sur une platine avec circuit imprimé. La LED est du type à montage inversé (aussi désigné « reverse mount » en anglais), à savoir que la LED émet ses rayons lumineux du côté de la face de la platine qui est opposée à la face sur laquelle la LED est montée. Pour ce faire, la platine comprend un orifice au travers duquel est insérée la partie optique de la LED. Cette dernière comprend une base avec deux extensions s'étendant latéralement de manière opposée, ces extensions comprenant des zones de contact destinées à être soudées aux zones de contact correspondantes de la platine. La platine et la base de la LED sont en matériau classique de circuit imprimé, à savoir en résine époxy renforcée de fibres de verre. Un tel matériau est conçu pour supporter des températures importantes imposées localement par les opérations de soudure classique. Le support de LED divulgué dans cet enseignement est intéressant pour des montages plans. Il l'est cependant moins pour les modules de signalisation à forme complexe.

Le document de brevet US 7,924,371 B1 divulgue un écran de système d'imagerie à vision nocturne. L'écran comprend une platine avec circuit imprimé sur laquelle est disposée une série de LED en réseau, destinée à rétro-éclairer un afficheur à cristaux liquides. Certaines des LED sont disposées sur la face avant de la platine, c'est-à-dire sur la face dirigée vers l'afficheur à cristaux liquides. D'autres LED sont en montage inversé, c'est-à-dire qu'elles sont disposées sur la face arrière de la platine, au travers d'orifices correspondants, de manière à éclairer vers l'avant au travers desdits orifices. La fixation et la connexion des LED avec les pistes électriques de la platine sont assurées par soudure classique. Similairement à l'enseignement précédent, le support de LED divulgué dans cet enseignement est intéressant pour des montages plans. Il l'est cependant moins pour les modules de signalisation à forme complexe.

Le document de brevet US 2005/0243558 A1 divulgue un support de LED pour un module de signalisation du type feux arrière de véhicule automobile. Il est constitué d'une platine avec circuit imprimé et comprenant une série d'orifices au travers desquels sont insérés des LED du type à montage inversé. Ces LED comprennent des parties optiques en forme de dômes, ces dômes étant visibles du côté de la face avant. Les LED comprennent des pattes de fixation et de connexion électrique soudées avec des pistes électriques sur la face arrière de la platine. Ce montage fournit un support esthétique lorsqu'il est observé depuis un point de vue situé du côté de la face avant, les connexions électriques étant exclusivement sur la face arrière. De plus, il permet la mise en place d'un radiateur sur la face arrière de la base de la LED. Similairement aux deux enseignements précédents, le support de LED divulgué dans cet enseignement est intéressant pour des montages plans. Il l'est cependant moins pour les modules de signalisation à forme complexe.

L'invention a pour objectif de proposer un support de LED palliant au moins un des inconvénients de l'art antérieur. Plus précisément, l'invention a pour objectif de proposer une solution au support de LED qui soit compatible avec un module de forme non plane, plus particulièrement de forme complexe. L'invention a également pour objectif de proposer un support de LED permettant de simplifier la construction d'un module de signalisation et, partant, de réduire son coût de production.

L'invention a pour objet un support de source(s) lumineuse(s) pour module lumineux notamment pour véhicule automobile, comprenant : un substrat avec au moins une ouverture et des pistes électriques sur au moins une face; au moins une diode à électroluminescence, dite LED, avec un corps et des pattes de connexion électrique latérales au corps ; la ou chacune des LED étant disposée au travers d'une ouverture respective du substrat, les pattes de connexion étant en contact avec les pistes électriques respectives; remarquable en ce que le substrat est une pièce moulée rigide présentant une forme en trois dimensions.

On entend par module lumineux un module d'éclairage pour éclairer la route devant le véhicule, ou un module de signalisation pour signaler la position du véhicule à d'autres usagers de la route, ou encore un module d'éclairage intérieur pour éclairer l'intérieur d'un habitacle du véhicule.

L'ouverte ou chacune des ouvertures est une ouverture traversant l'intégralité de l'épaisseur du substrat.

Dans un exemple de réalisation, le corps de la LED comporte une paroi supérieure présentant au moins une surface d'émission de lumière et une paroi latérale s'étendant autour de la paroi supérieure. Les pattes de connexion électrique latérales s'étendent avantageusement depuis la paroi latérale de manière sensiblement parallèle à la paroi supérieure. Avantageusement, la LED présente deux pattes de connexion électrique, disposées de part et d'autre du corps.

La ou les LED sont configurées pour éclairer du côté du substrat qui correspond à la face opposée à celle comprenant les pistes électriques.

Selon un mode avantageux de l'invention, le substrat forme une paroi présentant sur son étendue des variations de hauteur de plus de 10%, préférentiellement 20% de son étendue. Les variations de hauteur sont suivant une direction généralement perpendiculaire à un plan de référence. Ce dernier peut correspondre à une portion de la paroi, ou encore à son plan moyen. L'épaisseur de la paroi peut être généralement constante. Elle peut être comprise entre 0.5 et 3mm.

Selon un mode avantageux de l'invention, le substrat présente une ou plusieurs portions en forme de cavité et/ou de marche.

Selon un mode avantageux de l'invention, les pattes de la ou des LED sont reliées aux pistes électriques respectives par une colle chargée de particules métalliques, ladite colle étant préférentiellement une colle polymère apte à polymériser après application. L'utilisation de colle est intéressante en ce qu'elle permet d'éviter de faire subir au substrat des sollicitations thermiques.

Selon un mode avantageux de l'invention, les pattes de la ou des LED sont reliées aux pistes électriques respectives par du métal, par exemple du cuivre, ce métal étant déposé par un procédé de métallisation chimique. Le procédé de métallisation pour relier les pattes aux pistes peut notamment être réalisé en même temps que le procédé permettant la métallisation de ces pistes du substrat.

Selon un mode avantageux de l'invention, le support comprend un connecteur venu de matière avec le substrat.

Selon un mode avantageux de l'invention, le matériau du substrat est un thermoplastique dopé en particules métalliques de manière à permettre l'accrochage des pistes électriques.

Selon un mode avantageux de l'invention, le substrat comprend au moins un composant électronique relié électriquement à la diode ou à au moins une des LED par les pistes électriques. Le ou les composants peuvent être reliés électriquement et mécaniquement par une colle chargée de particules métalliques telle que décrite précédemment.

Selon un mode avantageux de l'invention, le substrat présente au moins une surface coopérant avec les rayons lumineux émis par la ou les LED de manière à assurer une fonction optique. Le substrat peut jouer à la fois le rôle de support de la ou des LED et le rôle de réflecteur.

Selon un mode avantageux de l'invention, la surface ou au moins une des surfaces du substrat coopérant avec les rayons lumineux est réfléchissante, absorbante ou diffusante.

Selon un mode avantageux de l'invention, le substrat comprend un revêtement réfléchissant, absorbant ou diffusant sur sa face opposée à celle des pistes électriques. Ce revêtement réfléchissant peut avantageusement être déposé via le même procédé de métallisation permettant de réaliser ces pistes.

L'invention a également pour objet un module de signalisation comprenant: un support de source(s) lumineuse(s); et une pièce optique, telle qu'un réflecteur, coopérant avec les rayons lumineux émis pas la ou les sources lumineuses; remarquable ce que le support est conforme à l'invention.

Selon un mode avantageux de l'invention, le support comprend la pièce optique, préférentiellement le support constitue la pièce optique.

L'invention a également pour objet un dispositif d'éclairage et/ou de signalisation, comprenant: un boîtier; un module lumineux disposé dans le boîtier; et une glace disposée sur le boîtier; remarquable en ce que le module est conforme à l'invention. Les mesures de l'invention sont intéressantes en ce qu'elles simplifient la réalisation du support de LED, en particulier pour les modules ou dispositifs de signalisation de forme complexe. En effet, dans le cas d'un module comprenant un grand nombre de LED réparties sur un réflecteur de forme complexe, comme par exemple une forme généralement courbée épousant l'arrondi à un des coins arrière d'un véhicule, et présentant une série de portions de surface réfléchissantes dirigées vers l'arrière du véhicule. Un tel réflecteur peut ainsi présenter une forme en gradins compatible avec une réalisation par moulage. En l'absence de l'invention, il serait nécessaire de réaliser une série de petits supports plans ou encore de prévoir un substrat allongé flexible (communément appelé « flex PCB » ou « circuit flex »), et de les ou le fixer de manière précise à la face arrière du réflecteur. Grâce à l'invention, le support peut épouser la face arrière du réflecteur ou encore assurer également la fonction du réflecteur.

D'autres caractéristiques et avantages de la présente invention seront mieux compris à l'aide de la description et des dessins parmi lesquels :
- La figure 1 est une illustration de principe d'un support selon un premier mode de réalisation de l'invention ;
- La figure 2 est une illustration de la LED présente à la figure 1 ;
- La figure 3 est une vue en coupe d'un dispositif de signalisation conforme au premier mode de réalisation ;
- La figure 4 est une illustration de principe d'un support selon un deuxième mode de réalisation de l'invention ;
- La figure 5 est une vue en coupe d'un dispositif de signalisation conforme au deuxième mode de réalisation ;
- La figure 6 est une vue en perspective d'un support conforme à un troisième mode de réalisation de l'invention.

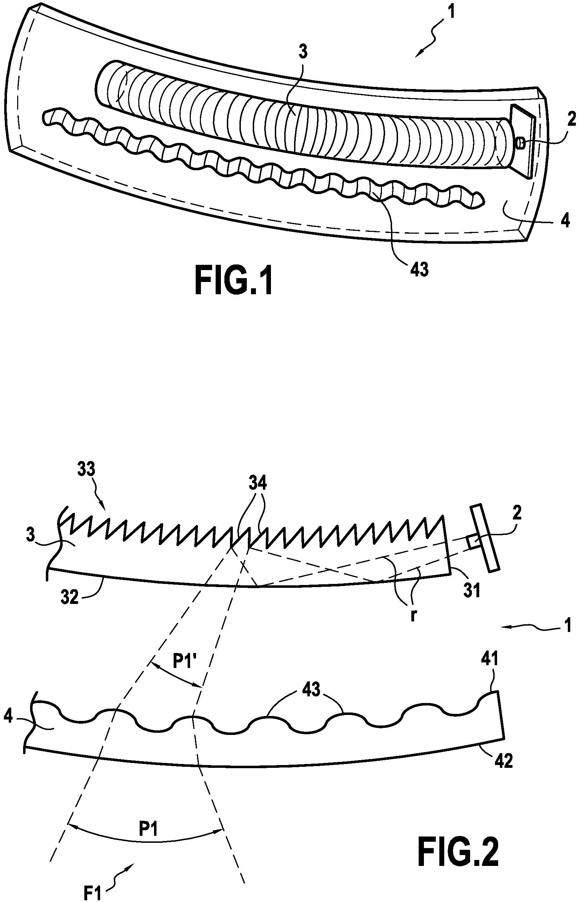

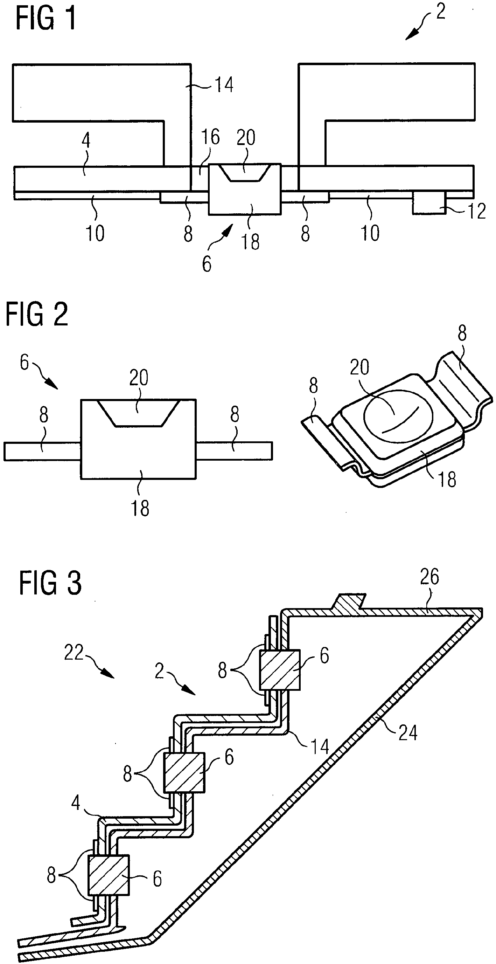

La figure 1 est une illustration de principe d'un premier mode de réalisation de l'invention. Cette illustration correspond à une vue en coupe ou de profil d'un support 2 comprenant un substrat 4 avec au moins un orifice 16 au travers duquel est disposé une diode à électroluminescence (LED) 6 du type à montage inversé (ou encore « reverse mount » en anglais). La LED 6 comprend un corps 18 avec une partie optique 20 et des pattes 8 de fixation et de connexion électrique. Le substrat 4 comprend des pistes électriques 10 sur sa face arrière, cette face correspondant à la face inférieure sur la figure. La LED 6 est mise en place sur la face arrière, de manière à ce que son corps 18 et plus particulièrement sa partie optique 20 pénètre au moins partiellement l'orifice 16. Les pattes 8 sont en contact mécanique et électrique avec les pistes électriques 10 correspondantes via une colle polymère dopée en particules métalliques ou via du cuivre déposé par procédé chimique.

La face arrière du substrat 4 peut comprendre un ou plusieurs composants électriques ou électroniques 12.

Un élément optique 14 est disposé sur la face avant du substrat 4 de manière à coopérer avec les rayons lumineux émis par la LED. Cet élément optique peut être du type réfléchissant, absorbant ou encore diffusant, ou encore une combinaison de ces derniers.

Contrairement à ce que la figure 1 peut laisser penser, le substrat est non plan, c'est-à-dire qu'il présente une forme en trois dimensions. Il est essentiellement constitué d'une paroi s'étendant avec des variations de hauteur de manière à former une forme en trois dimensions. Le substrat est réalisé par moulage d'un ou plusieurs matériaux plastiques. Le ou les matériaux est/sont préférentiellement thermoplastique. Le moulage peut ainsi être réalisé par injection de la matière dans un moule. Ce dernier, installé sur une presse, est constitué le plus souvent de deux coquilles correspondant à une partie fixe et une partie mobile qui sont fortement pressées l'une contre l'autre au moment du moulage puis écartées pour permettre l'éjection de la pièce moulée. Le moule peut également comporter un ou plusieurs noyaux destinés à former les parties creuses de la pièce et des poinçons permettant de réserver des ouvertures dans ses parois. On peut également placer dans le moule des inserts dans un autre matériau ou du moins une autre nuance, qui se retrouveront par la suite inclus dans la pièce.

Le matériau plastique du substrat peut être dopé en particules métalliques aptes à assurer l'accrochage de pistes métalliques sur sa surface extérieure. Cette technologie est couramment désignée par l'acronyme MID signifiant en langue anglaise « molded interconnect device ».

Les pistes électriques peuvent être réalisées par la technologie désignée par l'acronyme LDS signifiant en langue anglaise « Laser Direct Structuring ». Il s'agit de faire parcourir un rayon laser sur la surface correspondante du substrat, suivant la configuration des pistes à réaliser. Le rayon laser a pour effet de former une rugosité apte à favoriser l'accrochage. Cette étape est suivie d'une métallisation par trempage du substrat dans un ou plusieurs bains métalliques successifs.

Alternativement ou de manière complémentaire, les pistes électriques peuvent être réalisées par impression du type jet d'encre dont l'encre comprend des particules métalliques.

Les pistes peuvent également être réalisées par un moulage en deux étapes du substrat, ou encore désigné « Two shot molding » en langue anglaise. Il s'agit d'un processus de moulage par injection en utilisant deux résines différentes où une seule des deux résines est métallisable. Typiquement, la résine métallisable est de l'ABS et la résine non-métallisable est du polycarbonate. Le substrat est ensuite soumis à un processus de dépôt auto-catalytique où du butadiène est utilisé pour chimiquement rendre la surface rugueuse et permettre l'adhérence d'une couche primaire de cuivre.

En raison de la nature thermoplastique du substrat, l'utilisation de procédés de soudure classique pour les contacts électriques n'est pas adaptée. Les pattes de fixation et de connexion 8 de la LED sont ainsi fixées mécaniquement et électriquement par application d'une colle à base polymère et chargée en éléments métalliques. Il s'agit ainsi d'un procédé d'application dite « à froid » ne mettant pas à mal le substrat. Après polymérisation de la colle, celle-ci assure la fixation mécanique et électrique de la LED.

La figure 2 illustre la LED 6 de la figure 1. La vue de gauche est une vue en plan schématique correspondant à celle de la figure 1, alors que la vue de droite est une représentation en perspective d'une LED correspondante disponible commercialement. Dans les deux vues, on peut bien distinguer la nature inversée de la LED 6, ainsi que son corps 18, sa partie optique 20 et ses pattes de fixation 8. Plus particulièrement, à la vue de droite on peut observer la forme circulaire de la partie optique 20 et la section en escalier des pattes 8.

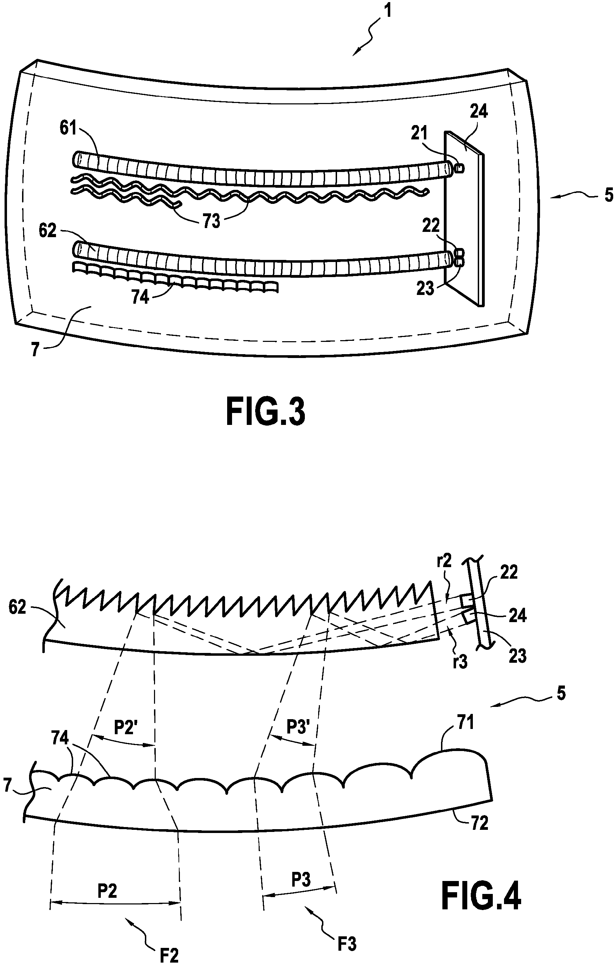

La figure 3 est une vue en coupe d'un dispositif de signalisation selon le premier mode réalisation, mettant en oeuvre le principe illustré à la figure 1. Le dispositif 22 comprend un boîtier 26 avec une glace 24 et un réflecteur 14. Ce dernier présente une forme en escalier avec une série d'orifices au travers desquels sont disposées les LED 6. Celles-ci sont fixées à un substrat 4 épousant au moins partiellement la forme en escalier du réflecteur 14. Le substrat moulé 4 peut épouser la forme du réflecteur ou du moins prendre une forme complexe apte à s'adapter ou se conformer à un réflecteur ou du moins un élément optique de forme non plane.

Le support 2 formé par le substrat 4 et les LED 6 qui y sont assemblées peut ainsi être mis en place directement sur les autres éléments du dispositif de signalisation.

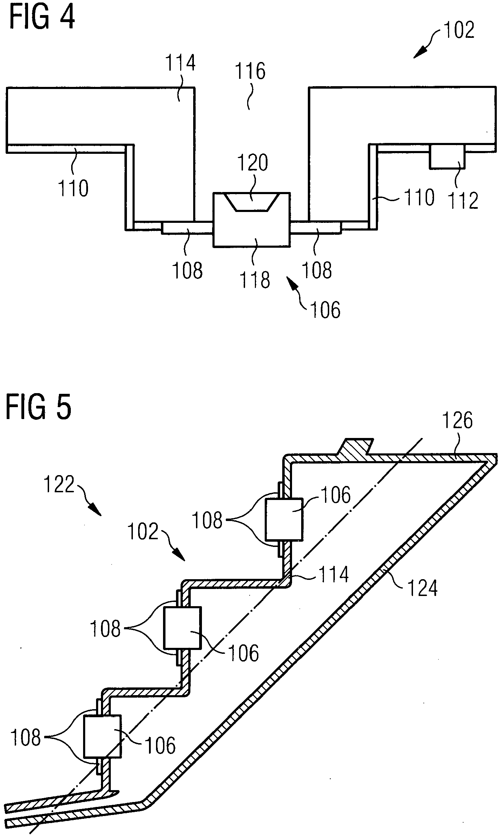

La figure 4 illustre de manière schématique un support de source(s) lumineuse(s) selon un deuxième mode de réalisation. Les numéros de référence du premier mode de réalisation sont utilisés pour les mêmes éléments ou les éléments correspondants du deuxième mode de réalisation, ces numéros étant toutefois majorés de 100 afin de bien distinguer les deux modes.

Le support 102 comprend un substrat 114 de forme non plane et assurant une fonction optique. Ce substrat 114 comprend des pistes électriques 110 sur sa face arrière. Il peut également comprendre un ou plusieurs composants électriques ou électroniques 112 sur sa face arrière, en connexion électrique avec les pistes électriques. Le substrat 114 comprend un orifice 116 au travers duquel est inséré, au moins partiellement, une LED 106. Celle-ci est de construction similaire à celle du premier mode de réalisation. Il s'agit d'un modèle de LED dit à montage inversé, c'est-à-dire destinée à être mise en place sur la face du substrat opposée à la face du côté de laquelle les rayons lumineux vont être émis. Le corps 118 de la LED 106 est ainsi inséré au travers de l'orifice 116 depuis la face arrière du substrat 114, de manière à ce que sa partie optique 120 regarde vers l'avant, c'est-à-dire du côté de la face avant du substrat 114. Lors de l'insertion de la LED 106, ses pattes 108 viennent en contact avec la face arrière du substrat 114, plus précisément avec les pistes électriques correspondantes 110. Le contact est assuré par de la colle dopée en métal. Cette colle est préférentiellement une colle de synthèse polymère, apte à polymériser après application à l'état pâteux. Il est fait référence à la description de la la fixation par colle du premier mode.

Comme cela est visible à la figure 4, le substrat est non plan, c'est-à-dire qu'il présente une forme en trois dimensions. Similairement au substrat du premier mode de réalisation, il est essentiellement constitué d'une paroi s'étendant avec des variations de hauteur de manière à former une forme en trois dimensions. Le substrat est réalisé par moulage d'un ou plusieurs matériaux plastiques. Il est fait référence à la description du premier mode de réalisation pour ce qui est du procédé de moulage du substrat.

Afin d'assurer une fonction optique, le substrat 114 peut être recouvert, notamment sur sa face avant ou du moins sur des portions de sa face avant, d'un revêtement réfléchissant, absorbant ou diffusant. Ce revêtement peut être appliqué par différents procédés bien connus en soi de l'homme de métier, tels que par métallisation pour un revêtement réfléchissant, ou par application d'une peinture absorbante ou diffusante.

La figure 5 est une vue en coupe d'un dispositif de signalisation selon le deuxième mode de réalisation, mettant en oeuvre le principe illustré à la figure 4. Le dispositif 122 comprend un boîtier 126 avec une glace 124 et un réflecteur 114. Ce dernier présente une forme en escalier et forme un substrat avec une série d'orifices au travers duquel et sur lequel sont directement disposées les LED 6. La face avant du substrat 114 est réfléchissante. Les LED 106 sont fixées à la face arrière du substrat 114 au moyen de leurs pattes 108. Le substrat moulé 114 peut ainsi prendre la forme d'un élément optique de forme complexe. Le montage du dispositif de signalisation est rendu ainsi particulièrement simple. Dans l'exemple de la figure 5, il est en effet constitué essentiellement de seulement trois éléments à assembler, à savoir le support équipé des LED 106, le boîtier 126 et la glace 124. Le boîtier et la glace peuvent former une seule pièce.

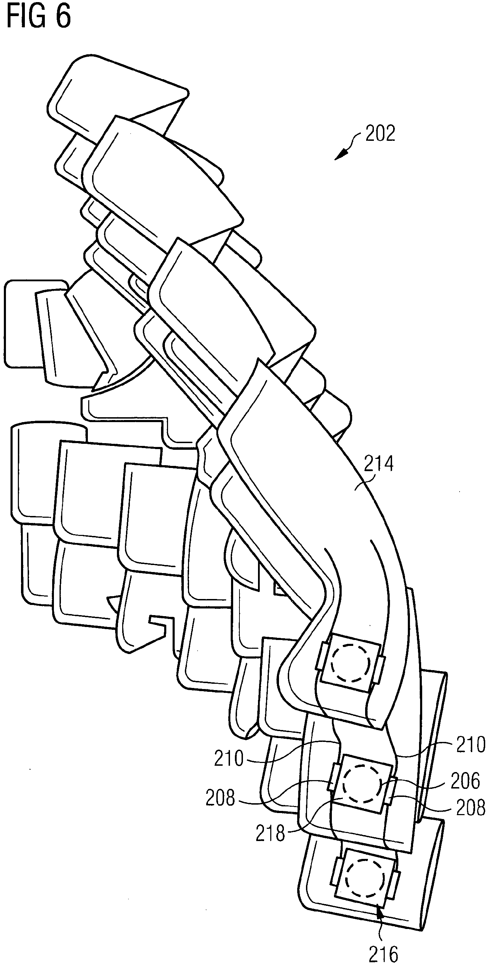

La figure 6 illustre un support de LED selon un troisième mode de réalisation de l'invention. Les numéros de référence du deuxième mode de réalisation sont utilisés pour les mêmes éléments ou les éléments correspondants de ce troisième mode de réalisation, ces numéros étant toutefois majorés de 100 afin de bien distinguer les deux modes.

Ce troisième mode de réalisation est similaire au deuxième mode des figures 4 et 5. Le support 202 comprend un substrat 214 de forme complexe avec une série de profils en escalier. La face avant (correspondant à la face de gauche sur la figure) est réfléchissante. Les LED 206 sont disposées et fixées sur la face arrière (correspondant à la face de droite sur la figure). Seules trois LED ont été représentées sur la figure, étant entendu que davantage de LED peuvent être présentes. Les pistes conductrices 210 sont formées sur la face arrière du substrat 214, de manière à s'étendre de manière continue de portion de surface en portion de surface et à relier les pattes 208 entre elles. La figure 6 montre ainsi une pièce optique de forme complexe apte à être formée par moulage de matière plastique et apte à servir de support de LED et de pistes électriques.

De manière générale, le substrat peut assurer d'autres fonctions telles que notamment celle d'un connecteur. Un connecteur peut en effet être moulé directement avec la matière du substrat. Il peut également comprendre un insert autour duquel la matière du substrat est moulée par injection. On peut également prévoir d'autres éléments sur le substrat assurant d'autres fonctions, comme notamment des pattes de fixation.

## Revendications

1. Support (2 ; 102 ; 202) de source(s) lumineuse(s) pour module lumineux (22 ; 122) notamment pour véhicule automobile, comprenant :
- un substrat (4 ; 114 ; 214) avec au moins une ouverture (16 ; 116 ; 216) et des pistes électriques (10 ; 110 ; 210) sur au moins une face ;
- au moins une diode à électroluminescence, dite LED (6 ; 106 ; 206), avec un corps (18 ; 118 ; 218) et des pattes de connexion électrique (8 ; 108 ; 208) latérales au corps ; la LED ou chacune des LED étant disposée au travers d'une ouverture respective (16 ; 116 ; 216) du substrat, les pattes de connexion (8 ; 108 ; 208) étant en contact avec les pistes électriques respectives (10 ; 110 ; 210) ;
**caractérisé en ce que**
le substrat (4 ; 114 ; 214) est une pièce moulée rigide présentant une forme en trois dimensions.

2. Support (2; 102; 202) selon la revendication 1, **caractérisé en ce que** le substrat (4; 114; 214) forme une paroi présentant sur son étendue des variations de hauteur de plus de 10%, préférentiellement 20% de son étendue.

3. Support (2 ; 102 ; 202) selon l'une des revendications 1 et 2, **caractérisé en ce que** le substrat (4 ; 114 ; 214) présente une ou plusieurs portions en forme de cavité et/ou de marche.

4. Support (2 ; 102 ; 202) selon l'une des revendications 1 à 3, **caractérisé en ce que** les pattes (8 ; 108 ; 208) de la ou des LED (6 ; 106 ; 206) sont reliées aux pistes électriques respectives (10; 110; 210) par une colle chargée de particules métalliques, ladite colle étant préférentiellement une colle polymère apte à polymériser après application.

5. Support (2 ; 102 ; 202) selon l'une des revendications 1 à 3, **caractérisé en ce que** les pattes (8 ; 108 ; 208) de la ou des LED (6 ; 106 ; 206) sont reliées aux pistes électriques respectives (10 ; 110 ; 210) par du métal, par exemple du cuivre, ce métal étant déposé par un procédé de métallisation chimique.

6. Support (2 ; 102 ; 202) selon l'une des revendications 1 à 5, **caractérisé en ce qu'**il comprend un connecteur venu de matière avec le substrat (4 ; 114 ; 214).

7. Support (2 ; 102 ; 202) selon l'une des revendications 1 à 6, **caractérisé en ce que** le matériau du substrat (4 ; 114 ; 214) est un thermoplastique dopé en particules métalliques de manière à permettre l'accrochage des pistes électriques.

8. Support (2 ; 102 ; 202) selon l'une des revendications 1 à 7, **caractérisé en ce que** le substrat (4 ; 114 ; 214) comprend au moins un composant électronique (12 ; 112) relié électriquement à la LED ou à au moins une des LED par les pistes électriques (10 ; 110 ; 210).

9. Support (102 ; 202) selon l'une des revendications 1 à 8, **caractérisé en ce que** le substrat (114 ; 214) présente au moins une surface coopérant avec les rayons lumineux émis par la ou les LED (106 ; 206) de manière à assurer une fonction optique.

10. Support (102 ; 202) selon la revendication 9, **caractérisé en ce que** la surface ou au moins une des surfaces du substrat (114 ; 214), coopérant avec les rayons lumineux, est réfléchissante, absorbante ou diffusante.

11. Support (102 ; 202) selon l'une des revendications 9 et 10, **caractérisé en ce que** le substrat (114 ; 214) comprend un revêtement réfléchissant, absorbant ou diffusant sur sa face opposée à celle des pistes électriques.

12. Module de signalisation comprenant :
- un support (2 ; 102 ; 202) de source(s) lumineuse(s) (6 ; 106 ; 206) ; et
- une pièce optique (14 ; 114 ; 214), telle qu'un réflecteur, coopérant avec les rayons lumineux émis pas la ou les sources lumineuses ;
**caractérisé en ce que**
le support (2 ; 102 ; 202) est conforme à l'une des revendications 1 à 11

13. Module selon la revendication 12, **caractérisé en ce que** le support (102 ; 202) comprend la pièce optique (114 ; 214), préférentiellement le support constitue la pièce optique.

14. Dispositif d'éclairage et/ou de signalisation (22 ; 122), comprenant :
- un boîtier (26 ; 126) ;
- un module lumineux disposé dans le boîtier ; et
- une glace (24 ; 124) disposée sur le boîtier ;
**caractérisé en ce que** le module est conforme à l'une des revendications 12 et 13.
